# EUROPÄISCHE PATENTSCHRIFT

(11) **EP 2 122 375 B1**
(45) Veröffentlichungstag und Bekanntmachung des Hinweises auf die Patenterteilung: **04.05.2011**
(21) Anmeldenummer: 08707065.2
(22) Anmeldetag: 16.01.2008
(51) Int. Cl.: G01R 31/28, G05D 23/19

(54) **TESTVORRICHTUNG ZUM TESTEN VON PRÜFLINGEN UNTER TEMPERATUR**
TEST DEVICE FOR TESTING TEST SAMPLES UNDER THERMAL CONDITIONS
DISPOSITIF DE TEST POUR TESTER DES ÉCHANTILLONS SOUS CONDITIONS THERMIQUES

(30) Priorität: 15.02.2007 DE 102007007529
(43) Veröffentlichungstag der Anmeldung: 25.11.2009
(73) Patentinhaber: Hatec Handhabungstechnik Maschinenbau Gmbh, 83052 Bruckmühl (DE)
(72) Erfinder: LINNERBAUER, Horst-Dieter, 83052 Bruckmühl (DE)
(74) Vertreter: Flach, Dieter Rolf Paul
(86) Internationale Anmeldenummer: PCT/EP2008/000296
(87) Internationale Veröffentlichungsnummer: WO 2008/098654

(56) Entgegenhaltungen:
- DE-A1- 4 031 793
- US-A- 6 104 183

## Beschreibung

Die Erfindung betrifft eine Testvorrichtung zum Testen von Prüflingen unter Temperatur nach dem Oberbegriff des Anspruches 1.

Elektronische Baukomponenten oder Baugruppen, die nachfolgend teilweise auch als Prüflinge oder Hybriden bezeichnet werden, müssen je nach Anforderung unterschiedlichen Tests unterzogen werden. Diese Tests dienen grundsätzlich zunächst einmal zur Überprüfung der elektrischen und elektronischen Funktionstüchtigkeit der zu überprüfenden Prüflinge oder Hybriden.

In vielen Fällen muss aber nicht nur die elektronische Funktionstüchtigkeit bei einer normalen Umgebungstemperatur überprüft werden, sondern auch unter Extremstbedingungen bzw. auch unter Extremtemperaturen, beispielsweise bei bis zu über 100°C, sowie andererseits bis zu weit unter 0°C, beispielsweise bei mehr als -30°C oder mehr als - 40°C.

Andererseits soll im Hinblick auf die unterschiedlichsten Baugruppen und die immer schneller zum Zuge kommenden neuen Techniken das Testsystem so aufgebaut sein, dass es den Bedürfnissen nach Flexibilität zum einen und hoher Prüfqualität zum anderen Rechnung trägt.

Bekannt geworden sind beispielsweise stationäre Prüfanlagen mit einer Kammer mit frontseitiger Öffnung, in der ein Werkstückträger mit dem darauf befindlichen Prüfling oder Hybrid in das Kammerinnere gebracht werden kann. Nach dem Schließen der Kammer wird die Kammer dann auf die gewünschte Temperatur von beispielsweise 100°C oder 150°C erhitzt oder beispielsweise auf -40°C gekühlt, um die entsprechenden Prüf- und Testläufe durchzuführen.

Dazu werden in der Regel eine Vielzahl von Kontaktstiften auf einem Kontaktstiftträger verwendet, der bei verschlossener Kammer auf den Hybrid herabbewegt wird, um an den vorher festgelegten Kontakt- und/oder Lötstellen die Prüfmessungen durchzuführen.

Anschließend wird die Kammer wieder geöffnet, der Hybrid in der Regel vollautomatisch herausgefahren und ein nächster zu überprüfender Prüfling hineingeführt.

Das Dokument US 6,104,183 zeigt den relevanten Stand der Technik.

Aufgabe der vorliegenden Erfindung ist es, ausgehend von diesem bekannten Stand der Technik eine verbesserte Testvorrichtung zu schaffen.

Die Aufgabe wird erfindungsgemäß entsprechend den im Anspruch 1 angegebenen Merkmalen gelöst. Vorteilhafte Ausgestaltungen der Erfindung sind in den Unteransprüchen angegeben.

Vom Stand der Technik abweichend wird nunmehr ein anderes Grundkonzept für eine Testvorrichtung von Prüflingen und Hybriden vorgeschlagen.

Erfindungsgemäß sind nämlich nunmehr mehrere Kammern vorgesehen, die bevorzugt kontinuierlich oder getaktet der Prüfstation zugeführt werden. Mit anderen Worten wird die Prüfstation in der Regel stationär angeordnet, an welcher die mehreren Kammern mit den darin befindlichen Prüflingen hin befördert werden.

Dies bietet den Vorteil, dass beispielsweise die zu überprüfenden Hybriden bei Umgebungs- oder Raumtemperatur in einer Zuführstation eingesetzt und die Kammern bereits dann geschlossen werden können. Diese Kammern werden kontinuierlich oder getaktet der Prüfstation zugeführt, wobei bereits auf diesem Weg eine Vortemperierung möglich ist. Unmittelbar vor oder bei Erreichen der Prüfstation kann noch der letzte Schritt des Temperierungsvorganges bis zum Erreichen der gewünschten Temperatur weiter durchgeführt werden. Anschließend kann die Kammer aus der Prüfstation herausbewegt, der Prüfling entfernt und die leere Kammer wieder zu einer Beschickungsstation zurückgefahren werden.

Dieses Konzept weist eine Reihe von Vorteilen auf, nämlich
- Die Kammern werden nicht permanent temperiert. Insbesondere bei Durchführung von Testmessungen im Frostbereich, beispielsweise bei -30°C bis -40°C, wird dabei einer möglichen Vereisungsgefahr einer stationären Kammer entgegengewirkt. Denn bei den stationären nicht verfahrbaren Kammern gemäß dem Stand der Technik müssen diese stets gekühlt werden, was bedeutet, dass die

Prüflinge in die bereits vorgekühlte Kammer eingefügt, die Kühlung fortgeführt wurde bis der gewünschte Extremwert erreicht wurde, um dann nach Abschluss der Messungen die Kammer wieder zu öffnen und den Prüfling herauszuführen und einen neuen einzusetzen. Dabei ist stets Austauschluft in das Innere der Kammer gelangt, mit der Gefahr, dass hier Vereisungen auftraten.
- Der Prüfling muss im Rahmen der vorliegenden Erfindung im Bereich der Prüfstation selbst keinen Kammerwechsel vollziehen, wodurch die Handlingszeiten und Temperaturverluste minimiert werden.
- Der Prüfling oder Hybrid durchläuft den geschilderten Prozess schon auf seinem Weg zur Prüfkammer und von dieser wieder weg gemeinsam mit einem Werkstückträger. Dabei ist der Werkstückträger in der isolierten Kammer untergebracht. Es kann sogar die isolierte Kammer als Werkstückträger bezeichnet werden.
- Sollten einzelne Kammern defekt sein, so können diese problemlos aus der Anlage entnommen werden, ohne die Anlagenfunktion als solches zu stören. Neue bereit gehaltene Kammern können problemlos in den Prozess eingefügt werden.
- Schließlich würde auch ein notwendiger Eingriff in einer Kammer die Hybriden in den weiteren Kammern nicht in nachteiliger Weise beeinflussen.
- Dadurch, dass keine Transporteinrichtungen in den Kammern selbst notwendig sind (im Gegensatz zu stationären Stationen) befinden sich in den einzelnen Kammern auch geringere Massen, die somit leichter zu temperieren sind.
- Schließlich kann im Rahmen der Erfindung das zu temperierende Volumen für einen Hybrid optimal klein gehalten werden.
- Ferner erfährt der Hybrid im Rahmen der Erfindung keine Belastungen, da die Kammer eine schützende Transporthülle bietet.
- Als positiv muss auch die Minimierung der Gefahr elektrostatischer Schädigungen aufgrund des abgeschlossenen Transportweges betont werden.
- Am Ende des Mess- und Transportweges wird letztlich der Hybrid oder Prüfling unter Raumtemperatur wieder aus der Kammer genommen und auf ein Band gesetzt, so dass die Kammer dann leer zur Aufnahmeposition zurückgefördert werden kann. Aus dem Gesamtkonzept ist ersichtlich, dass stets mehrere Kammern gleichzeitig durch die Anlage bewegt bzw. getaktet fortbewegt werden können.

In einer besonders bevorzugten Ausführungsform weisen die Kammern für die erfindungsgemäße Testvorrichtung einen Schiebedeckel auf, der vorzugsweise auf der Oberseite der Kammer vorgesehen ist. Dies bietet die bevorzugte Möglichkeit, dass im Rahmen der eigentlichen Teststation beim Auflaufen der Prüfkammer der Schiebedeckel automatisch zurückgeschoben und durch eine Prüfwand der Prüfstation ersetzt wird. Mit anderen Worten läuft der Schiebedeckel der Kammer an die stationäre Prüfwand der Prüfstation auf, wobei die Kammer diese Prüfwand unterfährt, so dass die Anschlusswand der Prüfstation dann die Kammer isolierend abdeckt.

Als günstig hat sich ferner erwiesen, den Innenraum der Kammern über eine externe Heiz- oder Kühlvorrichtung aufzuwärmen bzw. zu kühlen. Bevorzugt sind entsprechende Steuereinrichtungen zumindest auch in den Kammern vorgesehen.

In einer weiteren bevorzugten Ausführungsform der Erfindung kann eine Verkürzung der Temperierzeiten durch passives Vortemperieren ermöglicht werden, indem die in einem letzten Temperierschritt zugeführte temperierte Luft, die noch sehr energiereich ist, nach Verlassen der betreffenden Kammer einer nachfolgenden Kammer zur Durchführung einer Vortemperierung zugeführt wird.

Weitere Vorteile, Einzelheiten und Merkmale der Erfindung ergeben sich aus den anhand von Zeichnungen nachfolgend dargestellten Ausführungsbeispielen. Dabei zeigen im Einzelnen:
- Figur 1 :: eine schematische Draufsicht auf das Grundkonzept der erfindungsgemäßen Test- vorrichtung;
- Figur 2 :: eine schematische räumliche Darstellung der erfindungsgemäßen Testvorrichtung;
- Figur 3 :: eine schematische perspektivische Darstel- lung einer erfindungsgemäßen Kammer;
- Figur 4 :: einen Schnitt durch eine Kammer mit einem integrierten Prüfling oder Hybrid;
- Figur 5 :: einen Schnitt durch zwei benachbarte Kam- mern zur Erläuterung des Vortemperier-Ver- fahrens;
- Figur 6 :: ein Diagramm zur Erläuterung der im Rahmen der Erfindung möglichen, dynamisch gere- gelten Temperierung;
- Figur 7 :: eine schematische räumliche Darstellung der Kontaktierstation zu dem Zeitpunkt, zu dem sich eine Kammer 1 noch neben der Kon- taktierstation in der Übergabeposition D befindet;
- Figur 8 :: eine entsprechende Darstellung zu Figur 8, bei der die Kammer 1 mit einem zu über- prüfenden Hybrid in die Kontaktierstation verfahren ist; und
- Figur 9 :: eine Schnittdarstellung durch die Über- gabe- und die Kontaktierstation.

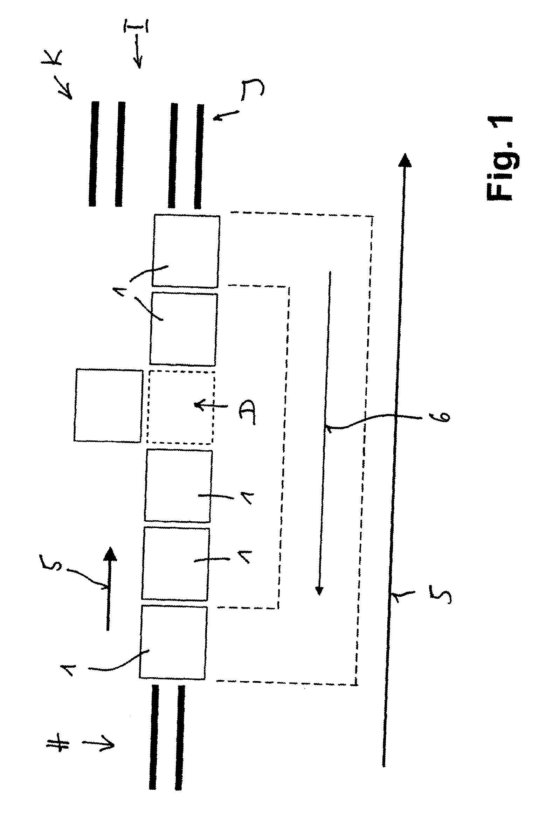

In Figur 1 ist in schematischer Draufsicht der Gesamtaufbau der Testvorrichtung gezeigt.

Daraus ist zu ersehen, dass im Rahmen der Testvorrichtung mehrere Kammern 1 vorgesehen sind, in denen einzelne zu überprüfende Prüflinge oder Hybride eingesetzt und die Kammern dann letztlich zu einer Teststation längs eines Vorschubweges 5 bewegt werden. Nach erfolgter Durchführung des Tests wird dann die betreffende Kammer über einen weiteren Wegabschnitt zum Entstücken vorbewegt, um dann als Leerkammer auf einem Rücktransportweg 9 zur Ausgangsposition bewegt zu werden. Die automatische getaktete Vorwärtsbewegung auf dem so gebildeten Umlaufweg 11 erfolgt durch geeignete Maßnahmen automatisch überwacht und gesteuert.

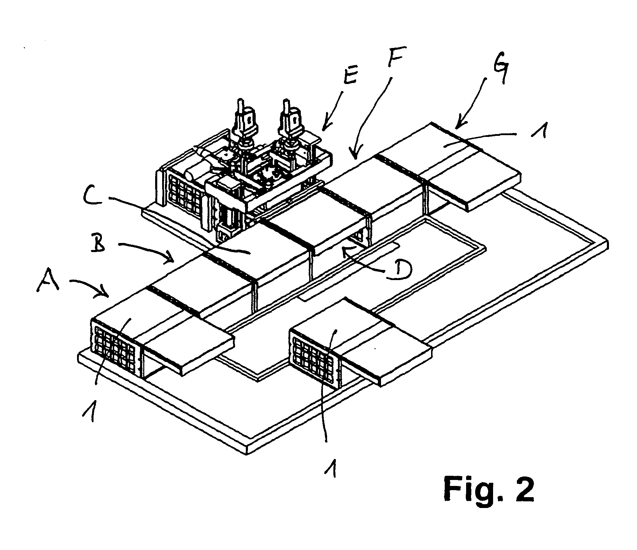

Bereits daraus wie auch unter Berücksichtigung der schematischen räumlichen Darstellung gemäß Figur 2 ist ersichtlich, dass die Testvorrichtung mehrere Stationen umfasst, nämlich beispielsweise eine Beladestation A, bei der die Kammer 1 mit einem zu testenden Prüfling oder Hybrid bestückt wird, einer nachfolgenden Vortemperier-Station B, bei der eine Vortemperierung des Kammerinneren und damit des Prüflings durchgeführt wird, einer nachfolgenden Temperier-Station C, bei welcher der Prüfling bereits auf die endgültige Temperatur gebracht wird. Daran schließt sich die dem eigentlichen Testschritt vorgelagerte Übergabeposition D an, die noch auf dem im gezeigten Ausführungsbeispiel gerade verlaufenden Vorschubweg 5 liegt. Wie nachfolgend noch näher erläutert wird, wird die Kammer 1 mit dem zu testenden Hybrid dann quer zu dem Vorschubweg 5 in die eigentliche Test- und Kontaktierstation E verfahren, die Tests durchgeführt, und dann die Kammer wieder an die Übergabeposition D zurückzufahren.

Während eines nächsten getakteten Schrittes werden dann alle Kammern um eine Kammerbreite weiter längs des Vorschubweges 5 verfahren, bis die in Rede stehende Kammer eine Rücktemperier-Station F erreicht, in der der Kammerinnenraum und damit der Prüfling entweder wieder in Richtung Umgebungstemperatur weiter aufgewärmt oder gekühlt wird.

Abschließend wird in einem nächsten getakteten Schritt dann die endgültige Entladeposition G erreicht, in der der Verschluss geöffnet und bei geöffnetem Deckel der getestete Prüfling oder Hybrid entfernt wird.

Anschließend kann dann der Kammerrücktransport durchgeführt werden, in der die in der Regel geöffnete Kammer 1' auf dem Rücktransportweg 9 zur Beladeposition A verfahren wird.

Dadurch wird also ein umlaufender geschlossener Transportweg 11 gebildet, der im gezeigten Ausführungsbeispiel einen gerade verlaufenden Vorschubweg 5 von der Beladeposition oder -station A bis zur Übergabe-Station.D und von dort über die Entladestation oder -position G wieder zur Ladestation A führt, wobei auf dem letzten Weg der Kammerrücktransport durchgeführt wird.

In Figur 1 ist auch noch eine Zuführ-Position H gezeigt, an welcher ein zu testender Hybrid oder Prüfling einer an der Ladeposition befindlichen Kammer 1 zugeführt wird. Am gegenüberliegenden Ende der Vorschubstrecke 5 ist dann an der Entladestation G benachbart eine Abtransportposition I vorgesehen, die im gezeigten Ausführungsbeispiel parallel so verschoben werden kann, dass ein erster Abtransportweg J oder ein zweiter Abstransportweg K benachbart zur Entladestation G zu liegen kommt. Der entsprechende Abstransportweg J oder K wird automatisch vom Prüfergebnis so verfahren, dass ein funktionstauglicher Prüfling auf dem Abtransportweg J für funktionstüchtige Prüflinge abtransportiert wird, wohingegen bei einem defekten Prüfling dieser über den Abstransportweg über funktionsuntüchtige Prüflinge aussortiert werden kann.

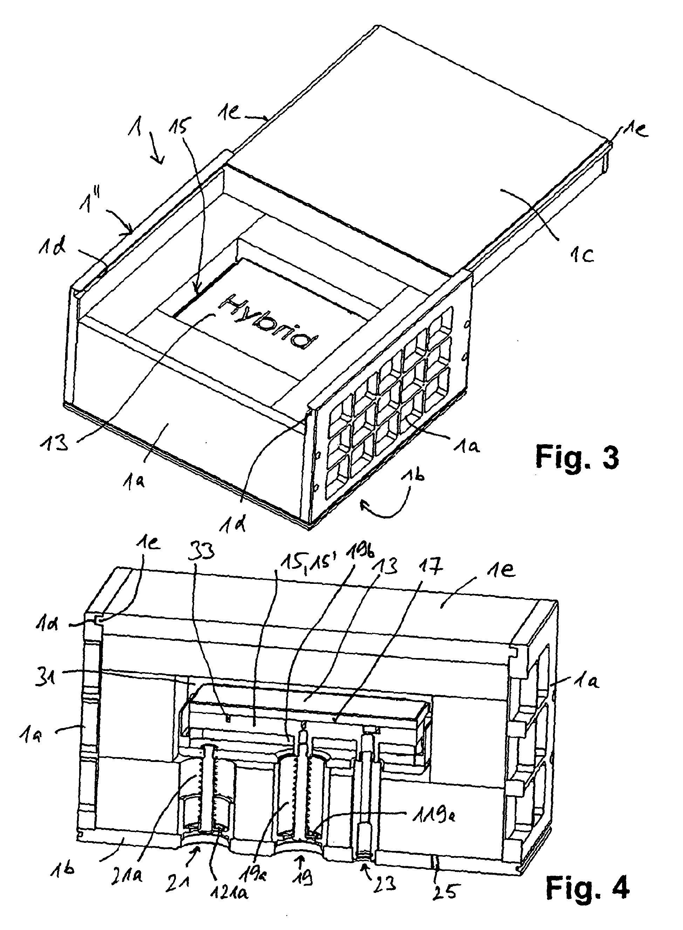

In Figur 3 ist in schematischer Darstellung eine der Kammern 1 gezeigt, die ein Kammergehäuse 1" mit vier Seitenwänden 1a, einen Boden 1b und einen Deckel 1c umfasst.

Der Deckel 1c ist im gezeigten Ausführungsbeispiel als Schiebedeckel gestaltet, der mit seitlich am Deckel vorgesehenen stegförmigen Vorsprüngen 1e in einer seitlichen Führung 1d an der oberen Innenseite zweier gegenüberliegender Wände 1a (beispielsweise nutförmige Führung) von einer geschlossenen in eine in Figur 3 gezeigte, geöffnete Darstellung und umgekehrt verschiebbar ist. Dabei ist in Figur 3 im Inneren der offenen Kammer ein Prüfling 13 gezeigt, der auf einem Werkstückträger 15 liegt, wobei der Werkstückträger im Inneren der Kammer angeordnet oder sogar Teil der Kammer ist. Die Kammer 1 könnte selbst als Werkstückträger 15 bezeichnet werden. In Figur 3 ist dabei die oben liegende Auflage des Werkstückträgers 15 nicht zu sehen, da sich auf der Oberseite des Werkstückträgers 15 ein zu überprüfender Prüfling 13 befindet, der mit der Aufschrift "Hybrid" gekennzeichnet ist.

Aus der Wiedergabe der Kammer 1 gemäß Figur 4 mit Blick in die Innenseite der Kammer ist zu ersehen, dass hier eine Reihe von Anschlüssen vorgesehen sein kann, beispielsweise (worauf später noch eingegangen wird) ein Zuführanschluss 19 zur Zuführung von Temperierluft (wobei Temperierluft allgemein für ein Temperiergas steht), eine Auslassöffnung 21, über welche die Temperierluft wieder nach außen abgeführt werden kann, einen Vakuumanschluss 23 (auf welchen später noch eingegangen wird) und beispielsweise zumindest einen Messanschluss 25 (der nur angedeutet ist), der mit einem im Kammerinneren vorgesehenen Temperaturfühler in Verbindung steht.

Aus dem in Figur 4 gezeigten, durch den Boden und den Deckel der Kammer 1 verlaufenden Vertikalschnitt ist zu ersehen, dass die Kammer 1 eine dicke Isolierung umfasst, also beispielsweise der freie Innenraum 31 der Kammer mit einer bis zu 40 mm dicken Isolierung umgeben sein kann.

Von dem Zuführanschluss 19 aus führt durch die Bodenplatte 16 hindurch ein Zuführkanal 19a, worüber temperierte Luft letztlich bis in das Kammerinnere 31 gelangt.

Im gezeigten Ausführungsbeispiel steht dabei der Zuführkanal 19a mit einem Kanalsystem 19b in Verbindung, der den eigentlichen Werkstückträger bildet, der nachfolgend teilweise auch als Temperierplatte 15' bezeichnet wird. Auf dieser Temperierplatte liegt der zu messende unter "Hybrid" bezeichnete Prüfling 13 auf.

Durch die entweder beim Aufheizen erwärmte oder beim Abkühlen gekühlte Luft wird somit eine Luftspülung erzeugt, die über den Zuführkanal 19a und das nachfolgende Kanalsystem 19b in der Temperierplatte diese auf die gewünschte Temperatur temperiert und damit auch den Prüfling vollflächig auf die gewünschte Temperatur anhebt oder absenkt. Anschließend strömt die entsprechend temperierte Luft über einen Auslass in der Temperierplatte in das Kammerinnere 31. Von dort, also vom Kammerinneren kann dann die zum Temperieren benutzte Luft (oder allgemein ein entsprechend temperiertes Gas) über einen zweiten, zum Zuführkanal 19a parallel verlaufenden Auslasskanal 21a zur Auslassöffnung 21 im Kammerboden 1b gelangen und dort abgeführt werden. Die Temperierung erfolgt also über eine temperaturgeregelte Luftspülung, wobei die Erwärmung oder Abkühlung der Luft über eine separate, in den Zeichnungen nicht näher dargestellte Temperiereinrichtung aufgeheizt oder abgekühlt wird. Bei einem derartigen Aufbau können Temperaturen von beispielsweise -70°C bis + 220°C erzeugt werden. Soll ein Prüfling beispielsweise aufgeheizt werden, so wird sich die entsprechend aufgeheizt zugeführte Luft während der Luftspülung durch Abgabe der Wärme leicht abkühlen und umgekehrt bei Kühlen eines Prüflings durch Aufnahme von Energie leicht erwärmen, so dass sich die Lufttemperatur an der Auslassöffnung 21 gegenüber der Zuführöffnung 19 solange unterscheidet, so lange das gesamte System sich nicht auf einer einheitlichen Temperatur befindet.

Aus dem Gesamtaufbau ist auch zu ersehen, dass der Einlass wie der Auslass für die Temperierluft über Ventile 119a und 121b gesteuert wird. Mittels dieser Ventile und einer entsprechenden Ventiltechnik werden die Zuführ- und Auslasskanäle geschlossen, wenn keine Anschlüsse 219, 221 unterhalb des Zuführanschlusses bzw. des Auslassanschlusses 19, 21 angedockt sind.

Der gezeigte Aufbau verdeutlicht ebenfalls, dass im Kammerinneren 31 das erwähnte Auflager 17 der Temperierplatte 15' vorgesehen ist, an der Vakuum- oder allgemein Unterdruckkanäle 33 offen enden, die mit einem vom Vakuumanschluss 23 ausgehenden Vakuumkanal 123 in Verbindung stehen. Über die Vakuumkanäle kann die Fixierung des auf der Auflageplatte 17 ruhenden Prüflings oder Hybrids 13 vor allem während der Kontaktierung in der Test- und Messstation unter Aufbringung eines Unterdrucks realisiert werden.

Die Auflageplatte 17 selbst wird über einen nicht näher dargestellten Temperatursensor stets temperaturüberwacht.

Die erwähnte Auflage- oder Temperaturplatte 17, die den oberen Abschnitt der erwähnten Temperierplatte 15' oder eine separate, auf der Temperierplatte 15' positionierte oder montierte separate Temperaturplatte darstellen kann, gewährleistet, dass die Temperatur über die Keramik auf die Bauteile übertragen wird. Durch die großflächige Temperierplatte wird die Temperatur zudem gleichmäßig auf den Hybrid 13 übertragen. Zudem ist auch das Umfeld bzw. der Kammerinnenraum temperiert.

Vor allem kann auch die Temperaturüberwachung mittelbar über die Temperierplatte bewerkstelligt werden, wodurch kein Temperatursensor mit dem Hybrid in Kontakt treten muss. Durch den kontinuierlichen Luftaustausch mit getrockneter temperierter Luft (oder einem sonstigen Gas) wird zudem sichergestellt, dass sich keine Betauung in der Kammer niederschlagen kann. Dabei wird die einströmende Lufttemperatur anhand der Temperatur der Auflageplatte geregelt.

Vor allem kann die Temperierung dynamisch anhand der Hybridtemperatur geregelt durchgeführt werden.

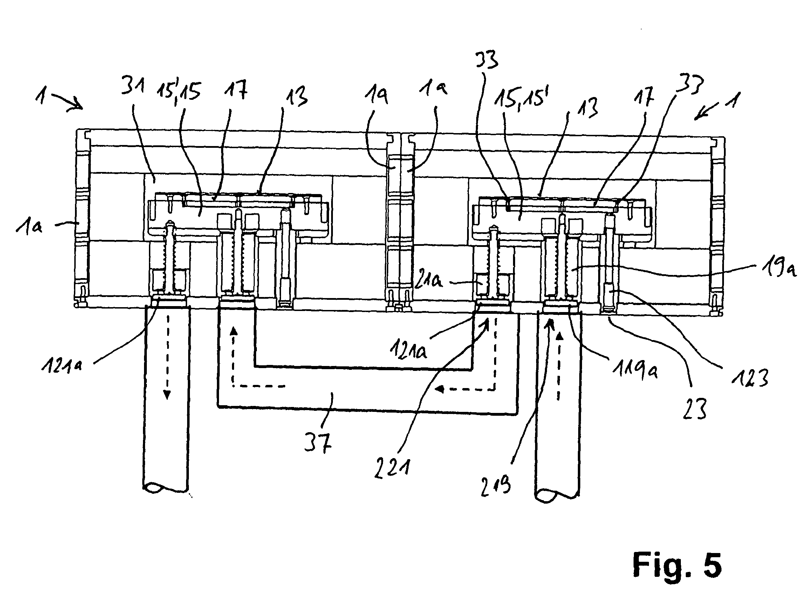

Schließlich ist aus der Schnittdarstellung gemäß Figur 5 auch zu ersehen, dass die Unterseite des Deckels 1c, die Innenseite der Wände 1a wie aber auch die Innenseite des Bodens 1b mit einer Dickenisolierung von bis zu 40 mm Dicke umgeben sind, um den Prüfling möglichst wirkungsvoll auf das gewünschte Temperaturniveau zu bringen.

Um die Temperierzeit zu verkürzen, wird die zur Temperierung verwendete Temperierluft auch nach dem Verlassen der Temperierkammer zur Durchführung einer Vortemperierung in einer anderen Kammer verwendet, wie dies anhand von Figur 5 näher dargestellt ist.

Figur 5 zeigt eine Kammer 1 an der endgültigen finalen Temperierstation C, also unmittelbar vor Durchführung des Testvorgangs in der Teststation. Sobald entsprechend der kontakteten Vorschubbewegung diese Kammer 1 die Teststation C erreicht, werden durch die erwähnte Ventilsteuerung der Zuführanschluss 19 und der Auslassanschluss 21 geöffnet, so dass über einen externen Zuführkanal dynamisch geregelte Temperierluft dem Kammerinneren zugeführt werden kann.

Dabei wird der Hybrid entsprechend auf die endgültige Messtemperatur gebracht. Die ausströmende Temperatur ist aber bei einem Erwärmungsvorgang immer noch sehr warm und bei einem Kühlvorgang vergleichsweise immer noch sehr kühl, so dass diese ausströmende Temperierluft über einen Verbindungskanal 37 unterhalb des Transportweges der Kammern 1 einer vorlaufenden benachbarten Kammer 1 zugeführt wird, die sich hier in einer Vortemperier-Station B befindet: Sobald auch diese Kammer die in Figur 5 gezeigte Position erreicht hat, können die entsprechenden Ventilanschlüsse an dem Zuführ- und dem Auslassanschluss 19, 21 geöffnet werden, um die erwähnte energiereiche Abluft in der vorlaufenden Kammer zur Vortemperierung zu verwenden.

Da die Kammern in der Regel getaktet gleichzeitig vorbewegt werden, befinden sich also die beiden Kammern gemäß Figur 5 zur gleichen Zeit an der Position C bzw. B, so dass die Ventile in der Regel gleichzeitig öffnen können.

Im gezeigten Ausführungsbeispiel wird die aus der Vortemperierkammer entweichende Abluft dann der externen Temperiereinrichtung (die in den Zeichnungen nicht näher gezeigt ist) zugeführt, um wieder auf die gewünschte, dynamisch geregelte Temperatur gebracht zu werden. Abweichend davon könnte aber der anhand von Figur 5 erläuterte Schritt auch noch in weiteren Schritten wiederholt werden, so dass die Abluft aus der Vortemperierkammer noch einer weiteren, nochmals vorlaufenden Kammer ebenfalls zur Durchführung eines nochmals vorausgehenden Vortemperierschrittes zugeführt wird etc.

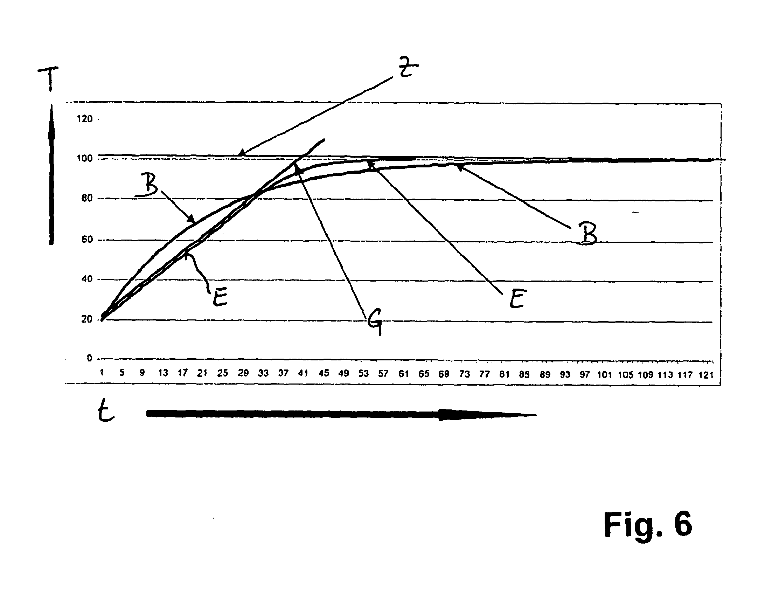

Im Rahmen der vorliegenden Testvorrichtung ist dabei eine dynamische Temperaturregelung möglich, wie sie anhand von Figur 6 erläutert ist.

In dem Diagramm gemäß Figur 6 ist bezüglich einer horizontal dargestellten Zeitachse t in Sekunden (sec) und bezüglich einer vertikal verkaufenden Temperaturachse T unter Darstellung von °C wiedergegeben, wie ein Hybrid oder Prüfling 13 entsprechend einer Temperaturkennlinie E exakt entlang einem maximal erlaubten Temperaturgradienten G erwärmt werden kann, bis aufgrund der dynamisch regulierten Kammertemperatur der Erwärmungsvorgang abflacht und die Temperatur des Prüflings dann die vorwählbare Zieltemperatur Z erreicht (im gezeigten Ausführungsbeispiel beispielsweise bei 100 °C.

Im Gegensatz dazu war im Stand der Technik eine Temperierung in der Regel nur gemäß Kennlinie B möglich, bei der die Aufheizung vor allem im unteren Temperaturbereich über den maximal erlaubten Temperaturgradienten G hinaus erfolgte und zudem die maximale Zieltemperatur auch erst sehr viel später erreicht wurde.

Durch die im Rahmen der Erfindung realisierte dynamisch geregelte Temperierung ist es also vor allem möglich (wie das Diagramm anhand von Figur 6 zeigt), dass die zu testende Baugruppe, also der Prüfling oder Hybrid, keinem unzulässigen Temperaturschock ausgesetzt wird. Es ist nunmehr sehr viel leichter, die Temperaturgeschwindigkeit durch einen vorwählbaren Gradienten zu begrenzen. Dabei steht die Baugruppe stets unter ständiger Temperaturüberwachung auch bereits in der Vortemperier- oder der finalen Temperierstufe. Zudem ist ein Einschwingen auf die Zieltemperatur im Rahmen durch den erfindungsgemäßen Aufbau durch die erläuterte Regelung in einem sehr viel kürzeren Zeitrahmen möglich, verglichen mit herkömmlichen Lösungen. Zudem kann durch den kontinuierlichen Luftaustausch mit getrockneter Luft, worauf bereits hingewiesen wurde, eine Betauung in der Kammer vermieden werden. Dabei lässt sich die Kammer gleichermaßen unter gekühlten wie aufgeheizten Bedingungen verwenden.

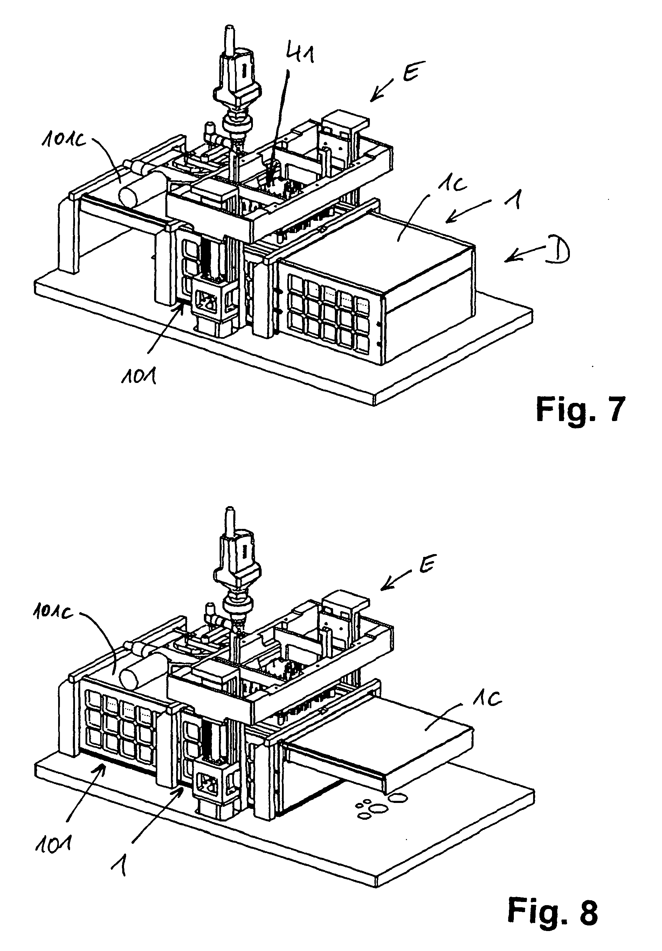

Abschließend wird nunmehr noch auf die Figuren 7 und 8 Bezug genommen.

In Figur 7 ist in alleiniger Darstellung eine bereits auf die endgültige Temperatur gebrachte Kammer 1 in ihrer Übergabeposition D gezeigt (unter Weglassung der anderen Kammern). In Figur 7 links neben der Kammer 1 befindet sich dann die eigentliche Mess-, Test- und/oder Kontaktierstation E.

Dazu wird die in Figur 7 rechts neben der Kontaktierstation befindliche Kammer 1 unter das Kontaktierfeld 41 verfahren, wobei der Deckel 1c in seiner Position verbleibt, so dass während des Verstellweges die Kammer 1 automatisch geöffnet wird. Da aber das Kontaktierfeld 41 stationär verbleibt, wird somit nur der Deckel nahtlos vom Kontaktierfeld ersetzt, ohne dass der Kammerinnenraum eine Verbindung zur Umgebung erhält. In dieser in Figur 8 gezeigten Position kann dann die entsprechende Messung durchgeführt werden, wozu - worauf hier nicht näher eingegangen wird - entsprechende Nadelfelder auf den zu überprüfenden Hybrid herabgesenkt werden, um die Messung durchzuführen.

Anschließend wird die Kammer 1 wieder von ihrer in Figur 8 gezeigten Position unter dem Kontaktierfeld 41 nach rechts verfahren, wobei nunmehr umgekehrt das Kontaktierfeld 41 nahtlos durch den Deckel 1c ersetzt wird, bis bei Erreichen der endgültigen Übergabeposition D die Kammer 1 wieder durch den eigenen Deckel 1c verschlossen ist.

Während des erläuterten Verstellschrittes von der Übergabeposition D zur Test- oder Kontaktstation E wird gleichzeitig aber noch eine in den Figuren 7 und 8 gezeigte Temperierkammer 101 parallel mit hin- und herverfahren. Die Temperierkammer 101 dient dazu, dass das Kontaktierfeld 41 stets ebenfalls auf der gewünschten Temperatur gehalten werden kann. Die Temperierkammer 101 wird dazu in ihrem Inneren ebenfalls auf der gewünschten Temperatur gehalten.

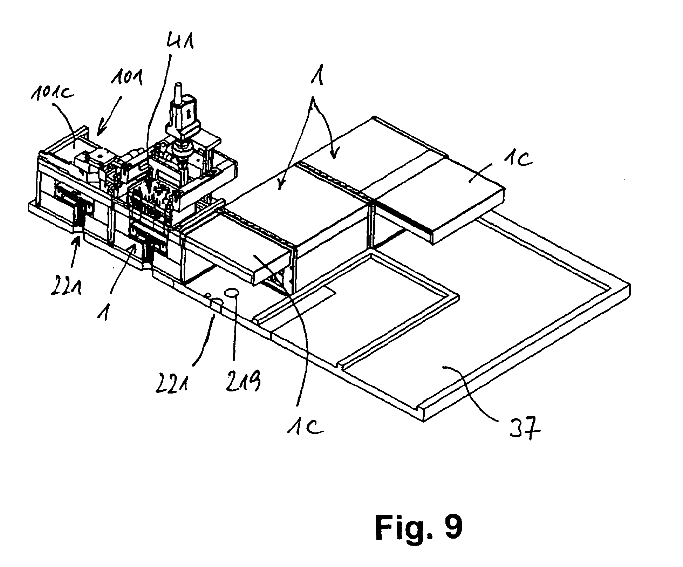

In Figur 9 (Schnittdarstellung) ist dabei ebenfalls wieder auf einer Grundplatte 51 einer der entsprechenden Anschlüsse für die Zufuhr von Temperierluft und die Abfuhr von Temperaturluft aus dem Inneren der Temperierkammer 101 sowie weitere Anschlüsse für einen im Inneren der Temperierkammer 101 untergebrachten Temperatursensor etc. gezeigt, mit denen die Temperierkammer 101 unter Zuführung der entsprechenden Temperierluft auf einer gewünschten Temperatur gehalten werden kann. Dieser Aufwärmvorgang erfolgt also bevorzugt nicht in der Position, in der sich die Temperierkammer 101 unter dem Messfeld befindet, sondern wenn sie wie gemäß Figur 8 in ihre Temperierposition verschoben ist, also zu einem Zeitpunkt, wo sich eine Kammer 1 mit einem Prüfling 13 direkt unter dem Kontaktfeld der Kontaktstation befindet.

Aus den Figuren 7 bis 9 ist auch zu ersehen, dass gegenüberliegend zur Übergabeposition D an der anderen Seite der Kontaktierstation bereits ein Deckel 101c stationär vorgesehen ist. Wird nämlich eine Kammer 1 mit der zugehörigen Temperierkammer 101 von ihrer in Figur 7 gezeigten in ihre in Figur 8 wiedergebene Lage verschoben, wandert dabei kontinuierlich die Temperierkammer 101 unter dem Kontaktfeld 41 heraus, wobei der stationäre Deckel 101c dabei kontinuierlich die Temperierkammer nach oben hin verschließt, so dass die Temperierkammer 101 während des gesamten Verstellweges ebenso nach außen hin abgedichtet verbleibt. Bei der Rückverstellung von der Position von Figur 8 nach Figur 7 läuft der Vorgang entsprechend umgekehrt ab.

## Patentansprüche

1. Testvorrichtung zum Testen von Prüflingen (13) unter Temperatur, mit folgenden Merkmalen:
- mit einem Werkstückträger (15), worüber ein zu überprüfender Prüfling (13) gehalten und/oder getragen wird,
- mit einer Kammer (1), in derem Inneren der Werkstückträger (15) vorgesehen ist,
- die Kammer (1) umfasst einen verschließbaren Deckel (1c), und
- mit einer Temperiereinrichtung zum Aufheizen oder Kühlen des Kammerinnenraumes (31) und/oder des Prüflings (13),
**gekennzeichnet durch** die folgenden weiteren Merkmale:
- es sind mehrere Kammern (1) vorgesehen,
- in den Kammern (1) ist jeweils zumindest ein zu überprüfender Prüfling (13) positionierbar,
- die Kammern (1) werden bereits vor Erreichen der Kontakt- und/oder Messposition (E) vortemperiert, und
- die Kammern (1) werden mit den darin befindlichen zu überprüfenden Prüflingen (13) der Test- und/oder Kontaktposition (E) zur Durchführung einer Prüfmessung zugeführt.

2. Testvorrichtung nach Anspruch 1, **dadurch gekennzeichnet, dass** die Kontakt- und/oder Teststation (E) stationär ist und die Kammern (1) relativ dazu, vorzugsweise getaktet verfahren werden.

3. Testvorrichtung nach Anspruch 1 oder 2, **dadurch gekennzeichnet, dass** die Kammern (1) einen Schiebedeckel (1c) aufweisen.

4. Testvorrichtung nach Anspruch 3, **dadurch gekennzeichnet, dass** eine Kammer (1) von einer Übergabeposition (D) in die Kontakt- und/oder Testposition (E) so verfahrbar ist, dass der Deckel (1c) relativ zur Kammer (1) von seiner Schließ- in seine Öffnungsstellung bewegt und dabei nahtlos von einem Kontaktierfeld (41) der Kontakt- und/oder Teststation (E) ersetzt wird.

5. Testvorrichtung nach einem der Ansprüche 1 bis 4, **dadurch gekennzeichnet, dass** im Bereich der Kontakt- und/ oder Messstation (E) eine Temperierkammer (101) vorgesehen ist, die sich unterhalb des Kontaktierfeldes (41) befindet, wenn sich eine Kammer (1) mit einem zu überprüfenden Prüfling (13) an anderer Position, insbesondere in einer Übergabestation (D) befindet, wobei die Temperierkammer (101) vorzugsweise gleichzeitig und gemeinsam mit der Kammer (1) mit dem zu überprüfenden Prüfling (13) so verfahrbar ist, bis die Kammer (1) mit dem zu überprüfenden Prüfling (13) sich in der Kontakt- und/oder Messposition unter dem Kontaktierfeld (41) befindet und die Temperierkammer (101) eine neben dem Kontaktierfeld (41) befindliche Warte- und/oder Temperierposition erreicht hat.

6. Testvorrichtung nach einem der Ansprüche 1 bis 5, **dadurch gekennzeichnet, dass** nach Durchführung eines Messvorganges die Kammer (1) zusammen mit der Temperierkammer (101) wieder so verfahren wird, dass die Kammer (1) die Übergabeposition (D) erreicht und die Temperierkammer (101) wiederum unter dem Kontaktierfeld (41) positioniert ist.

7. Testvorrichtung nach Anspruch 5 oder 6, **dadurch gekennzeichnet, dass** gegenüberliegend von der Übergabeposition (D) an der Kontakt- und/oder Teststation (E) ein stationärer Deckel (101c) vorgesehen ist, der die Temperierkammer (101) schließt, wenn die Temperierkammer (101) von ihrer Position unter dem Kontaktierfeld (41) in die Position unter dem stationären Deckel (101c) verfahren ist.

8. Testvorrichtung nach einem der Ansprüche 1 bis 7, **dadurch gekennzeichnet, dass** die Kammern (1) und vorzugsweise die Temperierkammer (101) über eine extern zu den Kammern (1) bzw. der Temperierkammer (101) liegende Temperiereinrichtung durch Zufügung eines entsprechend temperierten gasförmigen Mediums, insbesondere Luft, temperierbar sind.

9. Testvorrichtung nach einem der Ansprüche 1 bis 8, **dadurch gekennzeichnet, dass** in den Kammern (1) und vorzugsweise in der Temperierkammer (101), vorzugsweise in deren Boden (1b), zumindest ein Zuführanschluss (19) und ein Auslassanschluss (21) vorgesehen sind, worüber temperiertes Gas und insbesondere temperierte Luft dem Kammerinneren (31) vorzugsweise über Kanäle, die durch die den Prüfling (13) haltenden Auflager- und/oder Temperierplatte (17, 15') verlaufen, zuführbar und vom Kammerinneren (31) über einen Auslassanschluss (21) abführbar ist.

10. Testvorrichtung nach Anspruch 9, **dadurch gekennzeichnet, dass** im Bereich des Zuführ- und Auslassanschlusses (19, 21) Ventile (119a, 121a) vorgesehen sind, die nur dann geöffnet werden, wenn sich diese Zuführ- und Auslassanschlüsse (19, 21) über entsprechenden Anschlüssen (219, 221) im Transportweg (11) befinden.

11. Testvorrichtung nach einem der Ansprüche 1 bis 10, **dadurch gekennzeichnet, dass** die Kammern (1) vorzugsweise in deren Boden (1b) zumindest einen zusätzlichen Vakuumanschluss (23) aufweisen, worüber eine Verbindung über Vakuumkanäle bis zur Oberseite der Auflage (17) des Werkstückträgers (15) geführt ist, worüber ein darauf aufgelegter Prüfling (13) vor allem in der Kontakt- und Teststation (E) vakuumgesteuert angepresst gehalten wird.

12. Testvorrichtung nach Anspruch 11, **dadurch gekennzeichnet, dass** auf einer Auflagefläche (17) auf dem Werkstückträger (15) und/oder einer darauf befindlichen oder **dadurch** gebildeten Temperierplatte (15') obenliegende Vakuum- oder Unterdruckkanäle (33) ausgebildet sind, die über einen Vakuumkanal (123) oder einem Vakuumanschluss (23) eine Verbindung nach außen aufweisen, worüber über einen extern anlegbaren Unterdruck oder ein extern anlegbares Vakuum ein auf der Auflageplatte (17) aufgelegter Prüfling (13) fixierbar ist.

13. Testvorrichtung nach einem der Ansprüche 1 bis 12, **dadurch gekennzeichnet, dass** die Kammern (1) vorzugsweise in deren Boden (1d) zumindest einen Messanschluss (25) für die Durchführung einer Temperaturmessung im Kammerinneren umfassen.

14. Testvorrichtung nach einem der Ansprüche 1 bis 13, **dadurch gekennzeichnet, dass** zumindest zwei Temperierpositionen für die Kammern (1) vorgesehen sind, nämlich zumindest eine Vortemperier-Station (B) und eine Haupttemperier-Station (C), in der ein im Kammerinneren (31) befindlicher Prüfling (13) vorzugsweise auf seine endgültige Temperatur bringbar ist.

15. Testvorrichtung nach Anspruch 14, **dadurch gekennzeichnet, dass** der Auslassanschluss (21) einer Kammer (1) in einer der Kontakt- und/oder Messstation (E) näher liegenden Position über einen externen Kanal (37) mit dem Zuführanschluss (19) einer vorlaufenden Kammer (1) verbindbar ist, worüber die ausströmende temperierte Luft einer vorlaufenden Kammer (1) zur Durchführung einer Vortemperierung zuführbar ist.

16. Testvorrichtung nach einem der Ansprüche 1 bis 15, **dadurch gekennzeichnet, dass** die Kammern (1) auf einem geschlossenen Umlaufweg (11) von einer Ladestation (A) über eine oder mehrere Temperierstationen (B, C) bis zu einer Übergabeposition (D) und von dort über eine Rücktemperaturstation (F) zu einer Entladestation (G) vorzugsweise getaktet bewegbar sind.

17. Testvorrichtung nach Anspruch 16, **dadurch gekennzeichnet, dass** eine entleerte Kammer (1) von der Entladeposition (G) über einen Rücktransportweg (9) zu einer Beladestation (A) transportierbar ist.

18. Testvorrichtung nach einem der Ansprüche 1 bis 17, **dadurch gekennzeichnet, dass** eine Kammer in der Übergabestation (D) quer aus dem Vorschubweg (5) in die Kontakt- und/oder Messstation (E) und zurück verfahrbar ist.

## Claims

1. Test device for testing test samples (13) under thermal conditions, comprising the following features:
- it comprises a workpiece carrier (15), which holds and/or carries a test sample (13) to be examined,
- it comprises a chamber (1), in the interior of which the workpiece carrier (15) is provided,
- the chamber (1) comprises a lockable cover (1c), and
- it comprises a temperature control means for heating or cooling the chamber interior (31) and/or the test sample (13),
**characterised by** the following further features:
- a plurality of chambers (1) are provided,
- at least one test sample (13) to be examined can be positioned in each of the chambers (1),
- the chambers (1) are already temperature-controlled in advance before reaching the contact and/or measurement position (E), and
- the chambers (1), together with the test samples (13) which are to be examined and are arranged therein, are fed to the test and/or contact position (E) in order to carry out a test measurement.

2. Test device according to claim 1, **characterised in that** the contact and/or test station (E) is stationary and the chambers (1) are moved relative thereto, preferably in a clocked manner.

3. Test device according to either claim 1 or claim 2, **characterised in that** the chambers (1) comprise a slide cover (1c).

4. Test device according to claim 3, **characterised in that** a chamber (1) is displaceable from a transfer position (D) into the contact and/or test position (E), in such a way that the cover (1c) moves relative to the chamber (1) from its closed position into its open position and is seamlessly replaced by a contact field (41) of the contact and/or test station (E).

5. Test device according to any one of claims 1 to 4, **characterised in that** in the region of the contact and/or measuring station (E), a temperature control chamber (101) is provided which is arranged beneath the contact field (41) when a chamber (1) containing a test sample (13) to be examined is arranged in another position, in particular in a transfer station (D), the temperature control chamber (101) preferably being displaceable simultaneously and jointly with the chamber (1) containing the test sample (13) to be examined until the chamber (1) containing the test sample (13) to be examined is arranged in the contact and/or measurement position below the contact field (41) and the temperature control chamber (101) has reached a waiting and/or temperature control position adjacent to the contact field (41).

6. Test device according to any one of claims 1 to 5, **characterised in that** once a measurement process has been carried out, the chamber (1) together with the temperature control chamber (101) is moved again in such a way that the chamber (1) reaches the transfer position (D) and the temperature control chamber (101) is positioned below the contact field (41) again.

7. Test device according to either claim 5 or claim 6, **characterised in that** a stationary cover (101c) is provided on the contact and/or test station (E), opposite the transfer position (D), and closes the temperature control chamber (101) when the temperature control chamber (101) is moved from its position below the contact field (41) into the position below the stationary cover (101c).

8. Test device according to any one of claims 1 to 7, **characterised in that** the chambers (1) and preferably the temperature control chamber (101) can be temperature-controlled by a temperature control means which is arranged externally to the chambers (1) and the temperature control chamber (101) by adding a correspondingly temperature-controlled gaseous medium, in particular air.

9. Test device according to any one of claims 1 to 8, **characterised in that** in the chambers (1) and preferably in the temperature control chamber (101), preferably in the bases (1 b) thereof, at least one feed terminal (19) and one outlet terminal (21) are provided, via which temperature-controlled gas and in particular temperature-controlled air can be fed to the chamber interior (31), preferably via ducts which extend through the support and/or temperature control plate (17, 15') holding the test sample (13), and can be removed from the chamber interior (31) via an outlet terminal (21).

10. Test device according to claim 9, **characterised in that** in the region of the feed and outlet terminals (19, 21), valves (119a, 121a) are provided which are only opened when said feed and outlet terminals (19, 21) are arranged above corresponding terminals (219, 221) in the transport path (11).

11. Test device according to any one of claims 1 to 10, **characterised in that** the chambers (1) comprise, preferably in the bases (1b) thereof, at least one additional vacuum terminal (23), via which a connection via vacuum ducts is guided to the upper face of the support (17) of the workpiece carrier (15), a test sample (13) which is placed on said support thus being held pressed against it, above all in the contact and test station (E), in a vacuum-controlled manner.

12. Test device according to claim 11, **characterised in that** upper vacuum or underpressure ducts (33) are formed on a support face (17) on the workpiece carrier (15) and/or on a temperature control plate (15') arranged thereon or formed thereby, and comprise an outward connection via a vacuum duct (123) or a vacuum terminal (23), via which connection a test sample (13) placed on the support face (17) can be fixed by an externally applicable underpressure or vacuum.

13. Test device according to any one of claims 1 to 12, **characterised in that** the chambers (1) comprise, preferably in the bases (1d) thereof, at least one measurement terminal (25) for taking a temperature measurement in the chamber interior.

14. Test device according to any one of claims 1 to 13, **characterised in that** at least two temperature control positions for the chambers (1) are provided, namely at least one advance temperature control station (B) and a main temperature control station (C), in which a test sample (13) arranged in the chamber interior (31) can preferably be brought to its final temperature.

15. Test device according to claim 14, **characterised in that** the outlet terminal (21) of a chamber (1) in a position close to the contact and/or measuring station can be connected via an external duct (37) to the feed terminal (19) of a leading chamber (1), it thus being possible for the outgoing temperature-controlled air to be fed to a leading chamber (1) in order to carry out advance temperature control.

16. Test device according to any one of claims 1 to 15, **characterised in that** the chambers (1) are movable, preferably in a clocked manner, on a closed circulation path (11), from a loading station (A) via one or more temperature control stations (B, C) to a transfer position (D), and from there via a rear temperature station (F) to an unloading station (G).

17. Test device according to claim 16, **characterised in that** an emptied chamber (1) is transportable from the unloading position (G) via a rear transport path (9) to a loading station (A).

18. Test device according to any one of claims 1 to 17, **characterised in that** a chamber in the transfer station (D) is displaceable transversely from the feed path (5) into the contact and/or measuring station (E) and back.

## Revendications

1. Dispositif de test pour tester des échantillons (13) en température, comprenant les éléments suivants :
- un porte-pièce (15), au moyen duquel un échantillon (13) à contrôler est maintenu et/ou porté,
- une chambre (1), à l'intérieur de laquelle est prévu le porte-pièce (15),
- la chambre (1) comprend un couvercle (1c) à fermer, et
- un dispositif de températion pour chauffer ou refroidir le volume intérieur (31) de la chambre et/ou l'échantillon (13),
**caractérisé par** les caractéristiques suivantes :
- il est prévu plusieurs chambres (1),
- au moins un échantillon (13) à contrôler est susceptible d'être positionné respectivement dans les chambres (1),
- les chambres (1) sont préalablement tempérées déjà avant d'atteindre la position de contact et/ou de mesure (E), et
- les chambres (1), avec les échantillons (13) à contrôler qui s'y trouvent, sont amenées à la position de test et/ou de contact (E) pour l'exécution d'une mesure de contrôle.

2. Dispositif de test selon la revendication 1, **caractérisé en ce que** la station de contact et/ou de test (E) est stationnaire, et les chambres (1) sont déplacées par rapport à celle-ci, de préférence en cadence.

3. Dispositif de test selon la revendication 1 ou 2, **caractérisé en ce que** les chambres (1) comprennent un couvercle coulissant (1c).

4. Dispositif de test selon la revendication 3, **caractérisé en ce qu'**une chambre (1) est déplaçable depuis une position de transfert (D) jusque dans la position de contact et/ou de test (E) de telle façon que le couvercle (1c) se déplace par rapport à la chambre (1) de sa position de fermeture à sa position d'ouvertures et est ici remplacée de façon continue par un champ de mise en contact (41) de la station de contact et/ou de test.

5. Dispositif de test selon l'une des revendications 1 à 4, **caractérisé en ce que** dans la région de la station de contact et/ou de mesure (E) il est prévu une chambre de températion (101) qui se trouve au-dessous du champ de mise en contact (41) quand une chambre (1) avec un échantillon à contrôler (13) se trouve à une autre position, en particulier dans une station de transfert (D), dans lequel la chambre de températion (101) est déplaçable de préférence simultanément et conjointement avec la chambre (1) avec l'échantillon à contrôler (13), jusqu'à ce que la chambre (1) avec l'échantillon à contrôler (13) se trouve dans la position de contact et/ou de mesure au-dessous du champ de mise en contact (41) et que la chambre de températion (101) a atteint une position d'attente et/ou de températion qui se trouve à côté du champ de mise en contact (41).

6. Dispositif de test selon l'une des revendications 1 à 5, **caractérisé en ce que**, après exécution d'une opération de mesure, la chambre (1) est à nouveau déplacée, conjointement avec la chambre de températion (101), de telle façon que la chambre (1) atteint la position de transfert (D) et que la chambre de températion (101) est à nouveau positionnée au-dessous du champ de mise en contact (41).

7. Dispositif de test selon la revendication 5 ou 6, **caractérisé en ce que**, à l'opposé de la position de transfert (D) à la station de contact et/ou de test (E), il est prévu un couvercle stationnaire (101c) qui referme la chambre de températion (101) quand la chambre de températion (101) est déplacée depuis sa position au-dessous du champ de mise en contact (41) jusque dans la position au-dessous du couvercle stationnaire (101c).

8. Dispositif de test selon l'une des revendications 1 à 7, **caractérisé en ce que** les chambres (1) et de préférence la chambre de températion (101) sont susceptibles d'être tempérées au moyen d'un système de températion situé à l'extérieur des chambres (1) ou respectivement de la chambre de températion (101) avec admission d'un milieu gazeux, en particulier de l'air, à température correspondante.

9. Dispositif de test selon l'une des revendications 1 à 8, **caractérisé en ce que**, dans les chambres (1) et de préférence dans la chambre de températion (101), de préférence dans leur fond (1b), il est prévu au moins un raccord d'alimentation (19) et un raccord de sortie (21), au moyen desquels un gaz tempéré et en particulier de l'air tempéré peut être amené à l'intérieur de la chambre (31), de préférence via des canaux qui s'étend à travers la plaque de pose et/ou de températion (17, 15') qui maintient l'échantillon (13) et peut être évacué depuis l'intérieur de la chambre (31) via un raccord de sortie (21).

10. Dispositif de test selon la revendication 9, **caractérisé en ce que**, dans la région du raccord d'alimentation et du raccord de sortie (19, 21) sont prévues des vannes (119a, 121a), qui sont ouvertes uniquement quand ces raccords d'alimentation et de sortie (19, 21) se trouvent dans le trajet de transport (11) via des raccords correspondants (219, 221).

11. Dispositif de test selon l'une des revendications 1 à 10, **caractérisé en ce que** les chambres (1) comportent, de préférence dans leur fond (1b), au moins un raccord à vide supplémentaire (23) au moyen duquel une liaison est guidée via des canaux à vide jusqu'à la face supérieure de la surface de pose (17) du porte-pièces (15), au moyen duquel un échantillon (13) posé sur celui-ci est maintenu pressé, sous la commande d'un vide, surtout dans la station de contact et de test (E).

12. Dispositif de test selon la revendication 11, **caractérisé en ce que** sur une surface de pose (17) sur le porte-pièces (15) et/ou sur une plaque de températion (15') qui se trouve sur celle-ci ou qui est formée par celle-ci, sont ménagés des canaux à vide ou à dépression situés en haut, qui présentent un une liaison vers l'extérieur via un canal à vide (123) ou via un raccord à vide (23), liaison au moyen de laquelle un échantillon (13), posé sur la plaque de pose (17), est susceptible d'être fixé au moyen d'une dépression ou d'un vide applicable de l'extérieur.

13. Dispositif de test selon l'une des revendications 1 à 12, **caractérisé en ce que** les chambres (1) comprennent, de préférence dans leur fond (1d), au moins un raccord de mesure (25) pour l'exécution d'une mesure de température à l'intérieur de la chambre.

14. Dispositif de test selon l'une des revendications 1 à 13, **caractérisé en ce qu'**il est prévu au moins deux positions de températion pour les chambres (1), à savoir au moins une station de températion préalable (B) et une station de températion principale (C), dans laquelle un échantillon (31) qui se trouve à l'intérieur de la chambre (31) peut être amené de préférence à sa température définitive.

15. Dispositif de test selon la revendication 14, **caractérisé en ce que** le raccord de sortie (21) d'une chambre (1) est susceptible d'être relié, dans une position située plus proche de la station de contact et/ou de mesure (E), via un canal externe (37) avec le raccord d'alimentation (19) d'une chambre située en avant (1), via lequel l'air tempéré sortant peut être alimenté à une chambre préliminaire (1) pour exécuter une températion préalable.

16. Dispositif de test selon l'une des revendications 1 à 15, **caractérisé en ce que** les chambres (1) sont déplaçables, de préférence de façon cadencée, sur un trajet fermé (11), depuis une station de chargement (A) via une ou plusieurs stations de températion (B, C) jusqu'à une position de transfert (D), et de celle-ci via une station de retour en température (F) jusqu'à une station de déchargement (G).

17. Dispositif de test selon la revendication 16, **caractérisé en ce qu'**une chambre vidée (1) est susceptible d'être transportée depuis la position de déchargement (G), via un trajet de transport de retour (9), jusqu'à une station de chargement (A).

18. Dispositif de test selon l'une des revendications 1 à 17, **caractérisé en ce qu'**une chambre dans la station de transfert (D) est déplaçable transversalement hors du trajet de progression (5) jusque dans la station de contact et/ou de mesure (E) et en retour.
